# EUROPEAN PATENT SPECIFICATION

(11) **EP 0 665 708 B1**
(45) Date of publication and mention of the grant of the patent: **01.04.1998**
(21) Application number: 95300537.8
(22) Date of filing: 27.01.1995
(51) Int. Cl.: H05K 9/00

(54) **Electrical screening**
Elektrische Abschirmung
Blindage électrique

(30) Priority: 28.01.1994 GB 9401648
(43) Date of publication of application: 02.08.1995
(73) Proprietor: NEOPOST LIMITED, Romford, Essex RM1 2AR (GB)
(72) Inventor: Levett, Irving, Dagenham, Essex RM10 7LT (GB)
(74) Representative: Loughrey, Richard Vivian Patrick

(56) References cited:
- WO-A-93/09650
- DE-U- 8 913 928
- FR-A- 2 673 496
- NEW ELECTRONICS, vol. 18, no. 14, July 1985 LONDON, GB, pages 69-70, 'Conductive paint protects against emi/rfi'

## Description

This invention relates to electrical screening of electronic apparatus to protect the electronic apparatus from the effects of electrostatic discharge and electromagnetic radiation.

Previously electronic apparatus has been housed in housing formed of metal which has a high electrical conductivity in order to prevent malfunctioning or damage to the circuits of such apparatus resulting from electrostatic discharges or electromagnetic radiation. However metal housings are costly to manufacture and undesirably increase the overall weight of the apparatus. Accordingly it is now common to house such electronic apparatus in housing constructed of synthetic plastics materials. Such synthetic plastics materials are relatively robust and enable the housings to be manufactured from mouldings of such materials, this being less costly than housings made of metal. However such plastics materials are not electrically conductive and do not provide any protection to the circuits housed therein against electrostatic discharges or electromagnetic radiation. Therefore it has been necessary to provide a conductive coating on the interior of the walls of the housing, the electrically conductive coating being connected to electrical ground, see for example FR-A-2 673 496. In order to provide the required degree of protection against electrostatic discharges and electromagnetic radiation the conductive coating needs to have a relatively high electrical conductivity and it has been common to use zinc as the material to form the coating. The zinc coating is applied as a hot spray process which is relatively costly to perform.

As an alternative to use of a metal coating, materials such as paint loaded with conductive particles have been used, for example copper loaded paint. These paints can be applied by a conventional paint spray gun and hence the process of applying the loaded paint is cheaper than the hot spray process required to form a zinc coating. However coatings formed of paint loaded with conductive particles do not have as low an electrical resistance as metallic coatings such as zinc. Thus although coatings of paint loaded with conductive particles may be fairly effective as regards providing a protective screen against electromagnetic radiation protection, the higher electrical resistance of such coatings results in the coatings being substantially less effective than coatings of metal in providing a good low resistance path to ground for high potential discharge and in the worst case could allow such a discharge to reach an electronic circuit intended to be protected by the screen. Even if the initial high potential discharge does not directly reach the electronic circuit, secondary discharges may occur within the housing and these discharges may create interference effects inside the electrical screening and result in malfunctioning of the circuits.

According to one aspect of the invention as claimed an electrical screen to provide protection to electronic circuits contained in a housing against high potential discharges and electromagnetic radiation includes an electrical ground terminal; a plurality of electrical paths of low electrical resistance extending on a surface of walls of the housing, said paths extending from spaced locations on said walls to said electrical ground terminal; and a layer of material having an electrical resistance higher than that of said paths deposited on said surface in electrical; contact with said paths.

According to a second aspect of the invention as claimed a method of fabricating an electrical screen on a surface of walls of a housing for electronic circuits including the steps of providing electrical tracks of a first material having a relatively low electrical resistance on the surface of the walls of the housing, said tracks extending from spaced locations of the surface to an electric ground terminal; and depositing on the surface a layer of second material having a higher electrical resistance than said first material; said electrical tracks being in electrical connection with said layer.

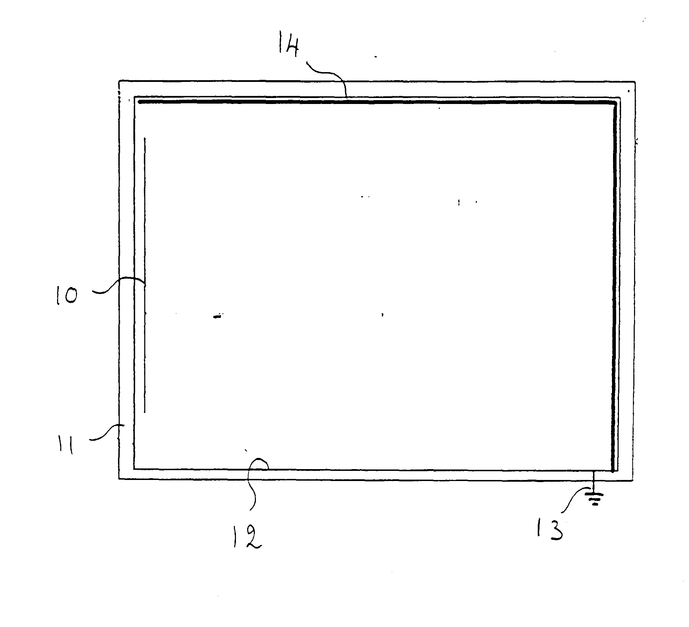

An embodiment of the invention will now be described by way of example with reference to the drawing which illustrates a housing for electronic circuits provided with screening in accordance with the invention.

Referring to the drawing, electronic circuits on a circuit board 10 are housed in a housing 11. The walls of the housing are formed of mouldings of synthetic plastics material, such synthetic plastics material being substantially electrically non-conductive. Electrical screening is provided by a layer 12 of paint loaded with electrically conductive particles deposited, for example by a conventional paint spray gun. The layer of paint makes electrical contact with an electrical ground terminal 13. Such a layer has a relatively low electrical resistance and is effective to provide protection against electromagnetic radiation for electronic circuits such as those on the circuit board 10 housed within the walls of the housing 11. However if a high potential discharge enters the interior of the housing, for example through an aperture in the wall of the housing or through a gap between wall components of the housing, the electrical resistance of the paint layer may be insufficiently low to ensure that the discharge is conducted wholly to the ground terminal 13. As a result the high potential discharge may partially discharge to the circuits on the circuit board or elsewhere in the housing or the potential difference between regions of the layer and the ground potential may be sufficiently high as to result in secondary discharges. These secondary discharges may discharge to the circuits or may create interference signals which cause malfunctioning of the circuits. In order to improve the effectiveness of the paint layer in providing a discharge path for high potential discharges, high electrical conductivity paths 14 are provided. These paths 14 make electrical connection with regions of the paint layer and are connected to the ground terminal 13. Thus the electrically conductive paths 14 provide low resistance, high conductivity, paths from regions of the paint layer to the ground terminal 13. The paths 14 may be formed of wires, foil strips or a wire mesh bonded to an interior surface of the walls of the housing and electrically connected directly to the ground terminal 13. A paint layer is then applied to the interior surface of the walls of the housing. The paint is loaded with conductive particles, for example of copper, and the layer of paint applied to the interior surface of the walls of the housing makes electrical contact with the electrical paths 14. The paths 14 may be applied generally over the interior of the entire walls of the housing or may be provided only to selected regions of the walls of the housing, such selected regions being at locations most susceptible to entry of high potential discharges into the housing. If desired the paths may be formed by deposition of metallic material along predetermined tracks on the interior surfaces of the walls of the housing. The layer of paint loaded with conductive particles provides a continuous conductive screen effective to provide protection to the circuits in the housing against electromagnetic radiation and the conductive paths provide low resistance paths for electric current arising from high potential discharges directly to the conductive paths and in addition provide low resistance paths from regions of the paint layer adjacent the conductive paths. Hence electric currents arising from high potential discharges to those regions of the paint layer adjacent the conductive paths are provided with a relatively low resistance path to ground via the conductive paths.

It will be appreciated that the combination of spaced conductive paths of low electrical resistance and a layer of material having a relatively higher electrical resistance electrically connected to the conductive paths as described hereinbefore provides a relatively inexpensive screen effective to provide protection to electronic circuits against both high potential discharges and electromagnetic radiation.

## Claims

1. An electrical screen to provide protection to electronic circuits (10) contained in a housing (11) against high potential discharges and electromagnetic radiation characterised by an electrical ground terminal (13); a plurality of electrical paths (14) of low electrical resistance extending on a surface of walls of the housing (11), said paths extending from spaced locations on said walls to said electrical ground terminal; and a layer (12) of material having an electrical resistance higher than that of said paths (14) deposited on said surface in electrical contact with said paths (14).

2. An electrical screen as claimed in claim 1 wherein said electrical paths (14) are formed of wire or foil bonded to the interior surface of the walls of the housing (11).

3. An electrical screen as claimed in claim 1 wherein said electrical paths (14) are formed by deposition of tracks of electrically conductive material on the interior surface of the walls of the housing.

4. An electrical screen as claimed in any preceding claim wherein the layer of material (12) comprises paint loaded with conductive particles.

5. A method of fabricating an electrical screen on a surface of walls of a housing (11) for electronic circuits (10) characterised by the steps of providing electrically conductive tracks (14) of a first material having a relatively low electrical resistance on the surface of the walls of the housing (11), said tracks (14) extending from spaced locations of the surface to an electric ground terminal (13); and depositing on the surface a layer (12) of second material having a higher electrical resistance than said first material; said electrically conductive tracks (14) being in electrical connection with said layer (12).

## Patentansprüche

1. Elektrische Abschirmung für den Schutz von in einem Gehäuse (11) untergebrachten elektronischen Schaltungen (10) vor Entladungen mit hohem Potential und vor elektromagnetischer Strahlung, gekennzeichnet durch eine elektrische Erdungsklemme (13), eine Mehrzahl von elektrischen Pfaden (14) mit niedrigem elektrischem Widerstand, die auf einer Oberfläche von Wänden des Gehäuses (11) verlaufen und sich von beabstandeten Stellen auf den Wänden zur elektrischen Erdungsklemme erstrecken, und eine Schicht (12) aus einem Material mit einem elektrischen Widerstand, der höher ist als derjenige der genannten Pfade (14), welche Schicht auf die genannte Oberfläche in elektrischem Kontakt mit den genannten Pfaden (14) aufgetragen ist.

2. Elektrische Abschirmung nach Anspruch 1, in welcher die elektrischen Pfade (14) von Draht oder Folie gebildet sind, welche an der inneren Oberfläche der Wände des Gehäuses (11) angebracht sind.

3. Elektrische Abschirmung nach Anspruch 1, in welcher die elektrischen Pfade (14) durch Ablagerung von Spuren aus elektrisch leitendem Material auf die innere Oberfläche der Wände des Gehäuses gebildet sind.

4. Elektrische Abschirmung nach einem der vorangehenden Ansprüche, in welcher die Materialschicht (12) mit leitenden Teilchen beladene Farbe enthält.

5. Verfahren zum Herstellen einer elektrischen Abschirmung auf einer Oberfläche von Wänden eines Gehäuses (11) für elektronische Schaltungen (10), gekennzeichnet durch folgende Schritte: Anbringen von elektrisch leitenden Spuren (14) aus einem ersten Material, das einen relativ niedrigen elektrischen Widerstand aufweist, an der Oberfläche der Wände des Gehäuses (11), welche Spuren (14) sich von beabstandeten Stellen der Oberfläche zu einer elektrischen Erdungsklemme (13) erstrecken, und Auftragen einer Schicht (12) aus einem zweiten Material, das einen höheren elektrischen Widerstand als das erste Material aufweist, auf die Oberfläche, wobei die elektrisch leitenden Spuren (14) mit der genannten Schicht (12) in elektrischer Verbindung stehen.

## Revendications

1. Blindage électrique pour fournir à des circuits électroniques (10) contenus dans un boîtier (11), une protection contre des décharges à haut potentiel et des rayonnements électromagnétiques,
caractérisé par
• une borne de masse électrique (13) ;
• un certain nombre de chemins électriques (14) à faible résistance électrique s'étendant sur une surface des parois du boîtier (11), ces chemins s'étendant entre des emplacements espacés sur les parois, et la borne de masse électrique ; et
• une couche (12) d'un matériau ayant une résistance électrique plus élevée que celle des chemins (14), cette couche étant déposée sur la surface et étant en contact électrique avec les chemins (14).

2. Blindage électrique selon la revendication 1,
dans lequel
les chemins électriques (14) sont formés par un fil ou une feuille soudés à la surface intérieure des parois du boîtier (11).

3. Blindage électrique selon la revendication 1,
dans lequel
les chemins électriques (14) sont formés par dépôt de pistes d'un matériau électriquement conducteur sur la surface intérieure des parois du boîtier.

4. Blindage électrique selon l'une quelconque des revendications précédentes,
dans lequel
la couche de matériau (12) est constituée par une peinture chargée de particules conductrices.

5. Procédé de fabrication d'un blindage électrique sur une surface de parois d'un boîtier (11) pour circuits électroniques (10),
caractérisé par
les étapes consistant à :
• former des pistes électriquement conductrices (14) d'un premier matériau ayant une résistance électrique relativement faible, sur la surface des parois du boîtier (11), ces pistes (14) s'étendant entre des emplacements espacés de la surface, et une borne de masse électrique (13) ; et
• déposer sur la surface une couche (12) d'un second matériau ayant une résistance électrique plus élevée que celle du premier matériau, ces pistes électriquement conductrices (14) étant connectées électriquement à la couche (12).
